(19)

Europäisches
Patentamt
European
Patent Office
Office européen
des brevets

(11) **EP 4 730 638 A1**

(12) **EUROPEAN PATENT APPLICATION**
published in accordance with Art. 153(4) EPC

(43) Date of publication:
**22.04.2026 Bulletin 2026/17**

(21) Application number: **24878648.5**

(22) Date of filing: **14.08.2024**

(51) International Patent Classification (IPC):
*H02P 5/48* (2016.01)   *H02P 21/00* (2016.01)

(86) International application number:
**PCT/CN2024/111958**

(87) International publication number:
**WO 2025/081996 (24.04.2025 Gazette 2025/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.10.2023 CN 202311357912**

(71) Applicant: **Zhe Jiang Siekon Transmission
Technology Co., Ltd
Jiaxing, Zhejiang 314500 (CN)**

(72) Inventors:
• **YU, Wenyong**
  **Jiaxing, Zhejiang 314500 (CN)**
• **ZHU, Yang**
  **Jiaxing, Zhejiang 314500 (CN)**
• **YANG, Chao**
  **Jiaxing, Zhejiang 314500 (CN)**
• **HUANG, Fengli**
  **Jiaxing, Zhejiang 314500 (CN)**

(74) Representative: **Metida
Gyneju str. 16
01109 Vilnius (LT)**

(54) **NVH CONTROL METHOD FOR SERIES-CONNECTED MOTOR SYSTEM**

(57)   Disclosed is a noise vibration and harshness (NVH) control method of a tandem motor system, which improves the NVH performance of a tandem motor by installing rotors of two motors in a misaligned manner, and calculates and finds an optimal misalignment angle between the two rotors through an optimization method, thereby minimizing an amplitude of a resultant cogging torque of the tandem motor to the greatest extent. The rotors adopt segmented skew structures. Additionally, the performance of the tandem motor is further enhanced through a multi-motor vector control technology and a phase-shifted pulse width modulation (PWM) control technology.

Fig. 1

EP 4 730 638 A1

## Description

## Technical Field

The present disclosure belongs to the technical field of motors and control thereof, and more specifically relates to a noise vibration and harshness (NVH) control method of a tandem motor system.

## Background

In recent years, the sales volume of new energy vehicles in China has witnessed rapid growth. Benefiting from the booming development of new energy vehicles, a complete industrial chain has been formed domestically, such as in the field of traction motor manufacturing.

However, the requirements for the power of drive motors vary with the supporting demands of different vehicle models. Although the variety of motors can be expanded by adjusting the thickness of stator and rotor laminations, it still fails to meet the needs of all vehicle models, and separate production lines have to be invested in to meet the demands for high-power applications.

On the other hand, there is a relatively high demand for high-power motors in the field of new energy commercial vehicles and the off-highway application fields. Nevertheless, the number of motor models available for matching is relatively limited currently, and developing new production lines will undoubtedly push up the manufacturing costs.

A tandem motor technology provides a solution to the aforementioned problems. This technology achieves power improvement by coaxially cascading existing motors. Based on the utilization of existing motor production equipment and production lines, it enables the manufacturing of motor products with a wider power range, which is currently a direction that the industry is striving towards.

Meanwhile, new energy vehicles have high requirements for the entire vehicle NVH performance. Particularly in the off-highway application fields, due to poor road conditions, not only motor products are required to have high mechanical stiffness, but also the various harmonic torques generated by a motor system itself are strictly limited to ensure the entire vehicle NVH performance.

The current NVH control technology is basically put forward for a single motor, and there are few NVH control technologies for tandem motors. Therefore, the present disclosure proposes a coordinated design technology and coordinated control technology for tandem motors to reduce or eliminate common harmonic torques, thereby achieving the purpose of optimizing the NVH performance of a tandem motor system.

## Summary

In view of the shortcomings of the prior art, the present disclosure provides an NVH control method of a tandem motor system, which can improve the NVH performance of a tandem motor.

In order to achieve the above object, the present disclosure provides the following technical solutions: an NVH control method of a tandem motor system includes a motor I and a motor II, and rotor shafts of the two motors are connected to each other to form a tandem motor; rotors of the motor I and the motor II are staggered with each other at an angle of $\Delta\theta$ when being installed, such that a resultant cogging torque of the tandem motor varies with $\Delta\theta$, where the maximum value of $\Delta\theta$, $\Delta\theta_{max}$, is determined by the number of stator slots Z and the number of rotor pole pairs $P_n$ of a motor, as shown in the following formula:

$$\Delta\theta_{max} = \frac{P_n}{Z} \cdot 360$$

when an amplitude of the resultant cogging torque varies with $\Delta\theta$, there exists an optimal $\Delta\theta_{opt}$ within a range of [0, $\Delta\theta_{max}$], at which the amplitude of the resultant cogging torque of the tandem motor is minimal; as shown in the figure, an angle of $\Delta\theta_{opt}$ is an optimal misaligned installation angle for the rotors of the motor I and the motor II; and a method for optimizing $\Delta\theta$ through a controller is as follows:

S1, installing the tandem motor on a test bench;
S2, dividing $\Delta\theta_{max}$ into N equal parts, denoted as $\Delta\theta_i = \Delta\theta_{i-1} + (i-1) \cdot \frac{\Delta\theta_{max}}{N}$, where $i$ = 1, 2, ... , $N$ + 1, and $\Delta\theta_0$ = 0;
S3, first setting $i$ = 1, and calculating a misalignment angle $\Delta\theta_i (i = 1)$ between the rotors of the motor I and the motor II when $i$ = 1;
S4, starting the tandem motor and waiting until a rotational speed of the tandem motor is stable;
S5, measuring and recording the resultant cogging torque of the tandem motor under the stable rotational speed state;
S6, stopping the motor and setting $i$ = $i$ + 1;
S7, determining whether $i$ is equal to $N$ + 1, if so, proceeding to the next step S8, and if not, returning to S3 and recalculating the misalignment angle $\Delta\theta_i$ based on a new value of $i$; and
S8, conducting a final analysis on a measured result to obtain the optimal $\Delta\theta_{opt}$.

Further, the motor I and the motor II are both three-phase motors, and adopt a multi-motor vector control technology to coordinately control electromagnetic torques of the motor I and the motor II in a unified manner.

Further, the tandem motor adopts a phase-shifted pulse width modulation (PWM) control technology.

Further, the rotors structures inside the motor I and the motor II adopt segmented skews.

Compared with the prior art, the present disclosure has the beneficial effects that: the magnetic poles between the rotors of the two single motors in the tandem motor are installed in a misaligned manner, and an optimal misalignment angle therebetween is calculated, so that the coordinated cogging torque of the tandem motor is minimized, and the coordinated NVH performance of the tandem motor is improved; by adopting the unified coordinated vector control technology for multi-phase motors, fixed-order harmonic torques are eliminated, and the coordinated NVH performance of the tandem motor is improved; the phase-shifted PWM control technology is adopted to weaken the high-frequency harmonic current of a DC bus, thereby reducing the loss of a DC bus capacitor, and lowering the requirement for the capacitance value of the capacitor and the controller cost; and in the event of a single motor failure, the tandem motor system still has the ability to output power, establishing the redundancy capacity of an electric drive system and improving the reliability of the system.

**Brief Description of Figures**

FIG. 1 is a schematic diagram showing the misaligned installation of rotors of a motor I and a motor II in a tandem motor system according to the present disclosure;
FIG. 2 is a schematic flowchart of a method for optimizing an angle of $\Delta\theta$ in a control method of a tandem motor system according to the present disclosure;
FIG. 3 is a schematic diagram of a resultant cogging torque in the tandem motor system according to the present disclosure;
FIG. 4 is a schematic diagram of harmonic torque cancellation in the tandem motor system according to the present disclosure; and
FIG. 5 is a schematic diagram of bus harmonic current attenuation in the tandem motor system according to the present disclosure.

**Detailed Description**

In the description of the present disclosure, it should be noted that for nouns of locality, the orientation and position relationships indicated by the terms such as "center," "horizontal (X)," "longitudinal (Y)," "vertical (Z)," "length," "width," "thickness," "up," "down," "front," "back," "left," "right," "upright," "lateral," "top," "bottom," "inside," "outside," "clockwise," and "counterclockwise" are based on the orientation or position relationships shown in the accompanying drawings, are only for convenience of describing the present disclosure and simplifying the description, and do not indicate or imply that the indicated device or element must have a specific orientation, or be constructed and operated in a specific orientation, and therefore cannot be understood as a limitation on the specific protection scope of the present disclosure.

Furthermore, terms such as "first" and "second" are used for descriptive purposes only and should not be interpreted as indicating or implying relative importance or implicitly specifying the quantity of technical features. Thus, features defined by "first" or "second" may explicitly or implicitly include one or more of such features. In the description of the present disclosure, the term "a number of" or "a plurality of" means two or more, unless explicitly defined otherwise.

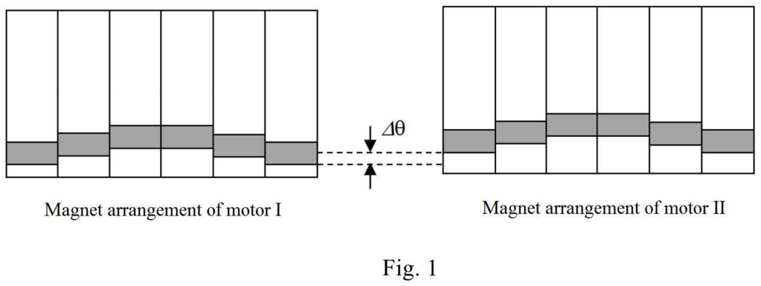

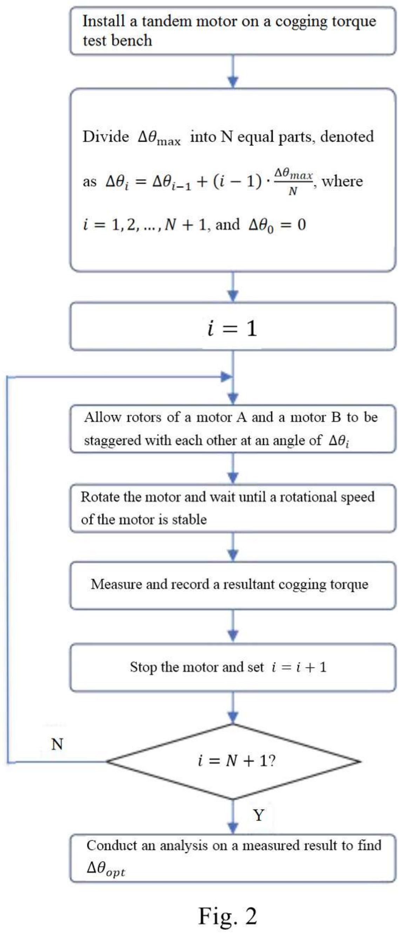

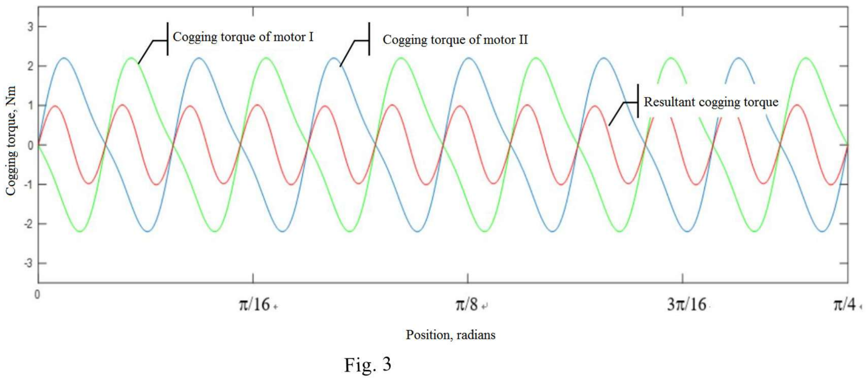

The present disclosure will be further described with reference to FIG. 1 to FIG. 5.

An NVH control method of a tandem motor system includes a motor I and a motor II, and rotor shafts of the two motors are connected to each other to form a tandem motor; rotors of the motor I and the motor II are staggered with each other at an angle of $\Delta\theta$ when being installed, such that a resultant cogging torque of the tandem motor varies with $\Delta\theta$, where the maximum value of $\Delta\theta$, $\Delta\theta_{max}$, is determined by the number of stator slots Z and the number of rotor pole pairs $P_n$ of a motor, as shown in the following formula:

$$\Delta\theta_{max} = \frac{P_n}{Z} \cdot 360$$

when an amplitude of the resultant cogging torque varies with $\Delta\theta$, there exists an optimal $\Delta\theta_{opt}$ within a range of [0, $\Delta\theta_{max}$], at which the amplitude of the resultant cogging torque of the tandem motor is minimal; as shown in the figure, an angle of $\Delta\theta_{opt}$ is an optimal misaligned installation angle for the rotors of the motor I and the motor II; and a method for optimizing $\Delta\theta$ through a controller is as follows:

S1, installing the tandem motor on a test bench;
S2, dividing $\Delta\theta_{max}$ into N equal parts, denoted as

$$\Delta\theta_i = \Delta\theta_{i-1} + (i-1) \cdot \frac{\Delta\theta_{max}}{N}$$, where $i$ = 1, 2, ... , $N$ + 1, and $\Delta\theta_0$ = 0;

S3, first setting $i$ = 1, and calculating a misalignment angle $\Delta\theta_i(i=1)$ between the rotors of the motor I and the motor II when $i$ = 1;
S4, starting the tandem motor and waiting until a rotational speed of the tandem motor is stable;
S5, measuring and recording the resultant cogging torque of the tandem motor under the stable rotational speed state;
S6, stopping the motor and setting $i$ = $i$ + 1;
S7, determining whether $i$ is equal to $N$ + 1, if so, proceeding to the next step S8, and if not, returning to S3 and recalculating the misalignment angle $\Delta\theta_i$

based on a new value of *i*; and
S8, conducting a final analysis on a measured result to obtain the optimal $\Delta\theta_{opt}$.

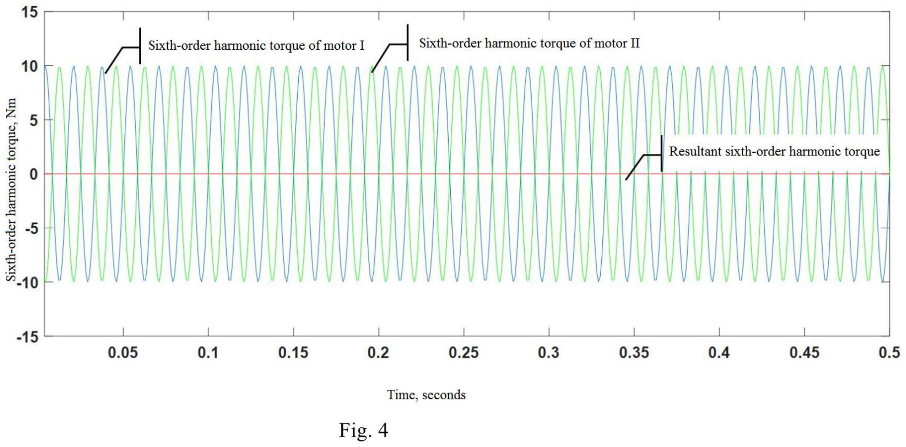

As shown in FIG. 4, preferably in this embodiment, the motor I and the motor II are both three-phase motors, and adopt a multi-motor vector control technology to coordinately control electromagnetic torques of the motor I and the motor II in a unified manner.

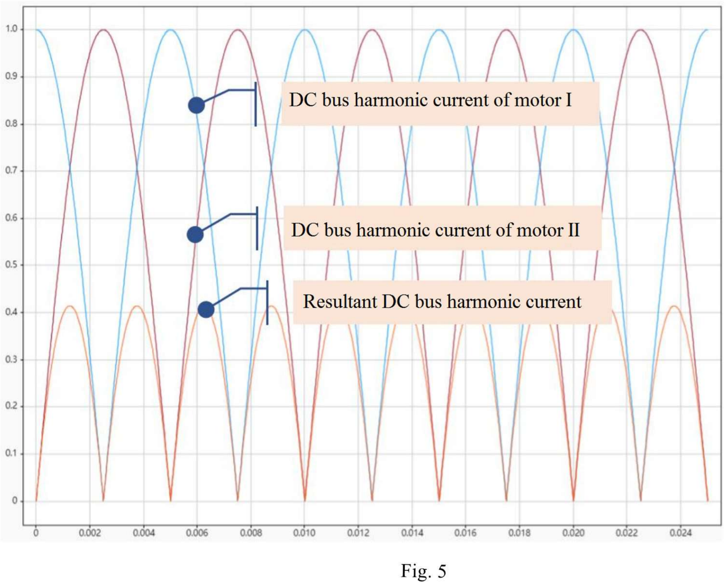

As shown in FIG. 5, preferably in this embodiment, the tandem motor adopts a phase-shifted PWM control technology.

Preferably in this embodiment, the rotors structures inside the motor I and the motor II adopt segmented skews.

The magnetic poles between the rotors of the two single motors in the tandem motor are installed in a misaligned manner, and an optimal misalignment angle there between is calculated, so that the coordinated cogging torque of the tandem motor is minimized, and the coordinated NVH performance of the tandem motor is improved; by adopting the unified coordinated vector control technology for multi-phase motors, fixed-order harmonic torques are eliminated, and the coordinated NVH performance of the tandem motor is improved; the phase-shifted PWM control technology is adopted to weaken the high-frequency harmonic current of a DC bus, thereby reducing the loss of a DC bus capacitor, and lowering the requirement for the capacitance value of the capacitor and the controller cost; and in the event of a single motor failure, the tandem motor system still has the ability to output power, establishing the redundancy capacity of an electric drive system and improving the reliability of the system.

The above description presents only preferred embodiments of the present disclosure, and the scope of protection of the present disclosure is not limited to the foregoing embodiments. All technical solutions falling within the idea of the present disclosure shall be considered within the scope of protection of the present disclosure. It is to be noted that those of ordinary skill in the art may make various modifications and refinements without departing from the principles of the present disclosure. Such modifications and refinements should also be regarded as falling within the scope of protection of the present disclosure.

**Claims**

1. A noise vibration and harshness (NVH) control method of a tandem motor system, comprising a motor I and a motor II, rotor shafts of the two motors being connected to each other to form a tandem motor, wherein rotors of the motor I and the motor II are staggered with each other at an angle of $\Delta\theta$ when being installed, such that a resultant cogging torque of the tandem motor varies with $\Delta\theta$, wherein the

maximum value of $\Delta\theta$, $\Delta\theta_{max}$, is determined by the number of stator slots Z and the number of rotor pole pairs $P_n$ of a motor, as shown in the following formula:

$$\Delta\theta_{max} = \frac{P_n}{Z} \cdot 360$$

when an amplitude of the resultant cogging torque varies with $\Delta\theta$, there exists an optimal $\Delta\theta_{opt}$ within a range of [0, $\Delta\theta_{max}$], at which the amplitude of the resultant cogging torque of the tandem motor is minimal; as shown in the figure, an angle of $\Delta\theta_{opt}$ is an optimal misaligned installation angle for the rotors of the motor I and the motor II; and a method for optimizing $\Delta\theta$ through a controller is as follows:

S1, installing the tandem motor on a test bench;
S2, dividing $\Delta\theta_{max}$ into N equal parts, denoted as

$$\Delta\theta_i = \Delta\theta_{i-1} + (i - 1) \cdot \frac{\Delta\theta_{max}}{N}, \text{wherein } i$$

= 1, 2, ... , N + 1, and $\Delta\theta_0 = 0$;
S3, first setting *i* = 1, and calculating a misalignment angle $\Delta\theta_i$ (*i* = 1) between the rotors of the motor I and the motor II when *i* = 1;
S4, starting the tandem motor and waiting until a rotational speed of the tandem motor is stable;
S5, measuring and recording the resultant cogging torque of the tandem motor under the stable rotational speed state;
S6, stopping the motor and setting *i* = *i* + 1;
S7, determining whether *i* is equal to N + 1, if so, proceeding to the next step S8, and if not, returning to S3 and recalculating the misalignment angle $\Delta\theta_i$ based on a new value of *i*; and
S8, conducting a final analysis on a measured result to obtain the optimal $\Delta\theta_{opt}$.

2. The NVH control method of a tandem motor system according to claim 1, wherein the motor I and the motor II are both three-phase motors, and adopt a multi-motor vector control technology to coordinately control electromagnetic torques of the motor I and the motor II in a unified manner.

3. The NVH control method of a tandem motor system according to claim 1, wherein the tandem motor adopts a phase-shifted pulse width modulation (PWM) control technology.

4. The NVH control method of a tandem motor system according to claim 1, wherein rotors structures inside the motor I and the motor II adopt segmented skews.

Magnet arrangement of motor I

$\Delta\theta$

Magnet arrangement of motor II

Fig. 1

EP 4 730 638 A1

Fig. 2

EP 4 730 638 A1

Fig. 3

Fig. 4

Fig. 5

## INTERNATIONAL SEARCH REPORT

| International application No. |
|---|
| **PCT/CN2024/111958** |

**A. CLASSIFICATION OF SUBJECT MATTER**

H02P5/48(2016.01)i; H02P21/00(2016.01)i

According to International Patent Classification (IPC) or to both national classification and IPC

**B. FIELDS SEARCHED**

Minimum documentation searched (classification system followed by classification symbols)

H02P

Documentation searched other than minimum documentation to the extent that such documents are included in the fields searched

Electronic data base consulted during the international search (name of data base and, where practicable, search terms used)

CNABS, CNTXT, ENTXT, ENTXTC, VEN, IEEE, CNKI: 串联, 电机, 马达, 双电机, 两电机, 转子, 轴, 齿槽, 转矩, 转速, 速度, series, motor, dual motor, rotor, shaft, stator, groove, tooth, torque, speed

**C. DOCUMENTS CONSIDERED TO BE RELEVANT**

| Category* | Citation of document, with indication, where appropriate, of the relevant passages | Relevant to claim No. |
|---|---|---|
| PX | CN 117424491 A (ZHEJIANG SIEKON TRANSMISSION TECHNOLOGY CO., LTD.) 19 January 2024 (2024-01-19)<br>description, paragraphs 9-22 | 1-4 |
| A | CN 109936320 A (FUZHOU UNIVERSITY) 25 June 2019 (2019-06-25)<br>description, paragraphs 23-140, and figures 1-9 | 1-4 |
| A | CN 115411852 A (NANJING UNIVERSITY OF SCIENCE AND TECHNOLOGY) 29 November 2022 (2022-11-29)<br>entire document | 1-4 |
| A | WO 2022050016 A1 (HITACHI ASTEMO, LTD.) 10 March 2022 (2022-03-10)<br>entire document | 1-4 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 November 2024** | **18 November 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/111958**

| Patent document cited in search report | | | Publication date (day/month/year) | Patent family member(s) | Publication date (day/month/year) |
|---|---|---|---|---|---|
| CN | 117424491 | A | 19 January 2024 | None | |
| CN | 109936320 | A | 25 June 2019 | None | |
| CN | 115411852 | A | 29 November 2022 | None | |
| WO | 2022050016 | A1 | 10 March 2022 | None | |

Form PCT/ISA/210 (patent family annex) (July 2022)